(19) Europäisches Patentamt
European Patent Office
Office européen des brevets

(11) Numéro de publication : **0 494 011 A1**

(12) **DEMANDE DE BREVET EUROPEEN**

(21) Numéro de dépôt : **91403502.7**

(51) Int. Cl.$^5$ : **G01N 17/00,** C23F 13/00

(22) Date de dépôt : **20.12.91**

(30) Priorité : **31.12.90 FR 9016551**

(43) Date de publication de la demande :
**08.07.92 Bulletin 92/28**

(84) Etats contractants désignés :
**AT BE CH DE DK ES GB GR IT LI LU MC NL SE**

(71) Demandeur : **GAZ DE FRANCE**
**23, rue Philibert Delorme**
**F-75017 Paris (FR)**

(72) Inventeur : **Callot, Pierre**
**54, rue de la Métairie**
**F-68100 Mulhouse (FR)**

(74) Mandataire : **Lerner, François et al**
**5, rue Jules Lefèbvre**
**F-75009 Paris (FR)**

(54) **Procédé et appareil pour analyser l'état de protection contre la corrosion d'un ouvrage sous protection cathodique.**

(57) L'invention a pour objet l'étude de l'évolution dans le temps de la tension entre une électrode (9) et un ouvrage métallique (1) enterré dans le sol (3) et censé être protégé contre la corrosion par un courant électrique.

Pour cette étude, on prévoit d'interrompre momentanément la circulation du courant de protection,de relever la tension entre l'ouvrage (1) et l'électrode (9), de faire passer ces relevés dans un filtre analogique (11), de lisser ces signaux filtrés en leur substituant des valeurs correspondant à une fonction postulée continue et monotone, puis, ladite opération de filtrage ayant distordu lesdits signaux, de reconstituer mathématiquement l'évolution des signaux de tension entre l'ouvrage et l'électrode telle qu'elle serait sans filtre analogique.

L'invention s'applique à l'étude de la protection cathodique des canalisations gazières.

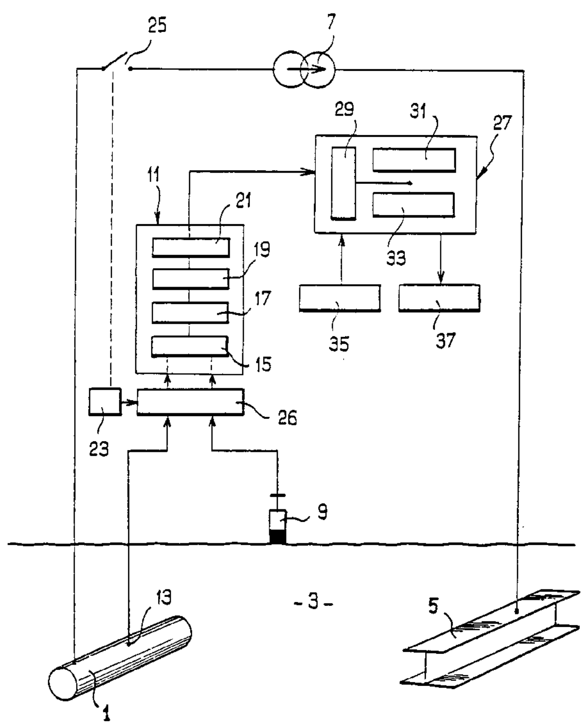


FIG.1

EP 0 494 011 A1

L'invention se rapporte à un procédé pour estimer l'état de protection contre la corrosion d'un ouvrage métallique en contact avec un milieu électrolytique et normalement protégé par voie cathodique ou anodique contre cette corrosion par une circulation imposée de courant entre l'ouvrage et une pièce formant contre-électrode, en contact avec ce milieu.

La protection cathodique est la plus largement répandue. Pour assurer cette protection on crée habituellement une circulation de courant électrique entre l'ouvrage métallique et la solution qui l'entoure, circulation telle que le sens du courant passe de la solution vers le métal, favorisant ainsi la réaction cathodique au niveau de l'ouvrage à protéger, en reportant la réaction d'oxydation sur la contre-électrode, formant alors anode.

Il existe également des cas où l'ouvrage forme anode et la contre-électrode cathode, (protection de certains métaux, tels l'aluminium, passivables dans l'électrolyte, via un courant de "protection anodique").

Quoi qu'il en soit, lorsqu'une protection "cathodique" ou "anodique" est appliquée à un ouvrage en contact avec le sol (ou un autre milieu électrolytique) l'efficacité de la protection est habituellement mesurée par la valeur de la différence de potentiel entre l'ouvrage et l'électrolyte.

Matériellement, cette tension est mesurée entre le métal de l'ouvrage protégé et une électrode complémentaire dite "de référence" en contact avec l'électrolyte. Dans la pratique, il est préférable de placer cette électrode de référence à l'écart de la surface censée être protégée.

La mesure de cette tension comporte donc un terme dû au gradient de potentiel dans le sol.

La connaissance du véritable potentiel métal/sol impose d'éliminer des mesures ce terme indésirable.

Un moyen habituellement utilisé dans ce but consiste à effectuer la mesure de ce potentiel, après coupure momentanée du courant imposé de protection. Une méthode à laquelle se sont ralliés de nombreux praticiens consiste à couper le courant de protection durant environ 3 secondes, la (ou les) mesure(s) étant effectuée(s) entre 2 et 3 secondes après la coupure, puis à rétablir le courant de protection pendant environ 30 secondes, avant une nouvelle coupure.

On sait donc aujourd'hui que pour vérifier en particulier l'état d'immunité vis-à-vis de la corrosion d'un ouvrage métallique enterré, il faut effectuer les mesures de potentiel de l'ouvrage par rapport au sol, courant de protection coupé, ceci pour éliminer de la mesure en particulier la chute ohmique due au passage du courant dans le sol. L'annulation de cette chute se fait en pratique en moins d'une milliseconde environ au moment de la coupure. On peut donc la considérer comme pratiquement instantanée.

Lorsque l'ouvrage passe de la situation "sous courant imposé de protection" à la situation de courant nul, il se produit également une modification du potentiel de l'ouvrage par rapport au sol. On considère que cette modification est due à des phénomènes électrochimiques se produisant essentiellement à l'interface entre le métal et le sol.

La connaissance du saut de potentiel qui se produit au moment de la coupure du courant de protection permet de savoir quel était le potentiel réel en situation de protection active de l'ouvrage.

La connaissance quantitative des amplitudes et vitesses d'évolution immédiatement après la coupure permet de déterminer quels sont les phénomènes électrochimiques qui entrent en jeu lorsque l'ouvrage, en partant de la situation de protection, évolue vers une situation de corrosion.

L'objet de l'invention est de permettre l'acquisition et l'analyse de ces phénomènes.

Or, dans la réalité, une analyse exhaustive et rigoureuse des paramètres correspondant à une situation réelle enregistrée est exclue.

Il a donc fallu, dans l'invention, simplifier le problème par modélisation.

Une première simplification a été obtenue en considérant que pendant l'intervalle de temps où le courant de protection est coupé, seul un phénomène électrique et deux ou trois phénoménes électrochimiques peuvent imposer la forme du signal obtenu.

Une seconde simplification a été tirée de l'observation que les principaux systèmes chimiques susceptibles de définir la valeur du potentiel entre métal de l'ouvrage et l'électrolyte sont en situation réelle nettement différenciés en potentiel et en constante de temps.

Par exemple, les valeurs de potentiel de :

$$H^{+} + e^{-} \rightarrow H$$

correspondant "aux concentrations" non infiniment petites d'hydrogène se situent à des valeurs très inférieures à celles du système :

$$Fe^{++} + 2e^{-} \rightarrow Fe$$

capables de donner une certaine stabilité au même potentiel.

Enfin, le système :

$$1/2\ O_2 + 2e_{-} + H_2 0 \rightarrow 2OH^{-}$$

se situe à des valeurs encore supérieures.

De plus, un troisième élément a du être pris en considération pour l'interprétation des mesures de tension

effectuées.

En effet, l'ensemble ouvrage/sol constituant un ensemble électrique qui est fréquemment l'objet de perturbations électriques, cela invite à l'utilisation de filtres pour atténuer les parasites à variation rapide.

Ces filtres déforment malheureusement aussi les variations d'origine électrique et électrochimique consécutives à la coupure.

Selon l'invention, on a éliminé ces déformations en appliquant des méthodes de filtrage et de traitement du signal par modélisation dont la validité découle de propriétés particulières au phénomène étudié.

Electriquement et électrochimiquement, le modèle retenu pour le système métal de l'ouvrage/sol devait évoluer après coupure toujours dans le même sens, tout phénomène oscillant étant exclu à l'échelle de la milliseconde.

En pratique, il a donc été prévu que les signaux de potentiel en fonction du temps fassent ainsi l'objet d'un échantillonnage et d'un filtrage analogique, puis d'un lissage par calcul mathématique permettant d'éliminer pratiquement tout phénomène oscillant.

En fait, une part importante de l'invention consiste en ce que l'on a postulé une évolution électrochimique monotone et continue (sans point singulier ni point d'inflexion) après le saut provoqué par la coupure du courant de protection.

Ce postulat peut se justifier théoriquement par les conditions de la thermodynamique irréversible régissant le passage d'un état de régime stable à un autre état de régime également stable pas trop éloigné du précédent, mettant en jeu les mêmes réactions.

Plus précisément, selon l'invention, le modèle en question postule une évolution du potentiel en fonction du temps constituée d'un saut de type ohmique, de préférence corrigé de la constante de temps électrique propre à l'ensemble l'ouvrage/sol, suivi de phénomènes d'origine électrochimique, de plus en plus lents.

Or, il a été constaté que pratiquement tous les phénomènes électrochimiques envisageables dans l'environnement considéré, reproduits en laboratoire en l'absence de parasites électriques, conduisent à des variations de potentiel qui sont le mieux représentées par des fonctions consistant en des sommes d'exponentielles et de polynômes.

La fonction suivante s'est en particulier avérée être un modèle tout à fait adapté.

$$V(t) = At + B + C_1\, e^{-t/\tau_1} + C_2\, e^{-t/\tau_2}$$

A, B, $C_1$, $C_2$, $\tau_1$, $\tau_2$ étant constantes telles que :

A : ordonnée à l'origine $t_o$ (instant de la coupure) de la composante linéaire,

B : pente de la composante linéaire,

$C_1$, $C_2$ : amplitudes des composantes exponentielles

$\tau_1$, $\tau_2$ : constantes de temps des composantes exponentielles

La variation de potentiel (et en particulier l'ensemble saut + somme d'exponentielles) étant, comme on l'a indiqué ci-dessus, malheureusement fortement déformée dans la partie à évolution rapide par l'opération indispensable de filtrage, il a donc en outre été imaginé un traitement mathématique permettant après lissage de retrouver la forme du signal qui, après convolution par la fonction de transfert du filtre, donne le signal de tension réellement enregistré.

En postulant que le signal de dépolarisation non déformé (donc non filtré) présente la forme du modèle présenté ci-dessus, il est ainsi devenu possible :

– d'éliminer tous les parasites résiduels non complètement éliminés par le filtre et de reconstituer un signal de tension non bruité. Il s'agit là de l'opération "d'identification" que l'on présente ci-après,

– puis de reconstituer la variation de potentiel qui aurait donnée, après passage par ledit filtre analogique, le signal obtenu ci-dessus, (c'est-à-dire, si l'on se réfère à la fonction postulée V(t) précédente, les valeurs correctes des constantes A, B, $C_1$, $C_2$, $\tau_1$, $\tau_2$ de cette fonction). Il s'agit là de l'opération dite de "déconvolution" également présentée ci-après.

Avant de décrire brièvement en quoi consistent mathématiquement ces deux opérations "d'identification" et de "déconvolution", on va rapidement présenter la structure de l'appareil utilisé dans l'invention en particulier pour mener à bien ces deux opérations et permettre ainsi à l'opérateur d'obtenir une image de la situation électrochimique existant dans la réalité entre le métal de l'ouvrage et le sol, au moment de la coupure.

Pour cela, on se réfèrera au dessins annexés dans lesquels :

– la figure 1 et un schéma d'ensemble montrant un appareil utilisable pour la mise en oeuvre de l'invention,

– et les figures 2 et 3 illustrent deux résultats de simulation relatifs à des signaux de tension ouvrage/électrode, d'une part non filtrés (figure 2) et d'autre part filtrés (figure 3).

Dans ce qui suit on ne traitera que du cas de la protection "cathodique". Toutefois l'invention est aussi applicable à la protection "anodique" évoquée ci-avant.

Sur la figure 1 tout d'abord, on aperçoit en 1 la canalisation métallique qui constitue dans cet exemple l'ouvrage électriquement conducteur dont on cherche à connaître l'état de protection contre la corrosion. Cette

canalisation 1 (éventuellement recouverte d'un revêtement de protection) est enterrée dans le sol 3 qui constitue en l'occurrence le milieu électrolytique. Dans ce sol et à proximité relative (par exemple à quelques dizaines de mètres) est également enterrée une pièce ou contre-électrode(ici "anodique") 5 reliée à la canalisation par un réseau électrique dans lequel circule un courant. Dans l'exemple choisi, un générateur de courant 7 débite dans le circuit un courant constant, ou continu, tel que la réaction naturelle d'oxydation est reportée sur la pièce 5 dont on accepte a priori la dégradation.

On notera brièvement que d'autres types de protection cathodique existent aujourd'hui, et notamment "par anode galvanique ou sacrificielle".

Pour mesurer la différence de potentiel ouvrage/sol, on utilise l'électrode 9 qui, posée sur le sol, joue le rôle d'électrode de référence. Cette électrode pourra par exemple être du type $Cu/CuSO_4$ ou Ag/Ag Cl.

Pour permettre la mesure et l'enregistrement de la tension entre l'ouvrage 1 et cette électrode 9, une unité de filtrage analogique 11 a bien entendu été en outre prévue, l'entrée de cette unité étant reliée, via l'unité de mesure 26, à l'électrode 9 ainsi qu'au capteur 13 branché sur le métal de l'ouvrage 1.

De préférence, l'unité de filtrage 11 comprendra, après un amplificateur différentiel 15 permettant de faire la différence entre les deux signaux issus des capteurs 9 et 13, deux réjecteurs de bande 17, 19 ainsi qu'un filtre passe-bas 21, par exemple du deuxième ordre.

Lors des essais qui ont été menés, les réjecteurs de bande 17 et 19 ont été choisis pour éliminer les fréquences respectivement de 50 et de 100 Hertz, tandis que le filtre passe-bas a été choisi pour éliminer toutes les fréquences supérieures à 120 Hertz. Mais bien entendu le choix de ces fréquences dépendra de l'application retenue.

Comme on le voit sur la figure 1, à l'unité de mesure 26 est également associée une horloge 23 pouvant être constituée par un chronorupteur permettant d'imposer la fréquence des relevés de mesure de tension, en relation avec un contact ou un interrupteur 25 prévu sur le circuit électrique reliant l'ouvrage 1 à la pièce anodique 5 pour interrompre et rétablir séquentiellement la circulation du courant de protection imposée par le générateur 7.

Une fois échantillonnés et filtrés, les signaux de tension "utiles" sont ensuite acquis puis traités de manière que l'opérateur puisse obtenir l'image recherchée de la situation électrochimique existant entre le métal et le sol avant et peu après la coupure du courant de protection.

Pour cela, le calculateur 27 comprend essentiellement une carte d'entrée/sortie 29, une unité mémoire 31 et un microprecesseur associé à une unité de calcul 33.

En pratique, la carte 29 pourra comprendre en entrée une série de canaux en mode direct ou en mode différentiel, un convertisseur analogique/numérique (A/N), un circuit échantillonneur-bloqueur, un système de multiplexage analogique, et, en sortie, une autre série de canaux avec conversion N/A. Une unité 35 (pouvant être constituée par une unité de disquettes associée à un contrôleur, ainsi qu'un clavier associé à sa carte de décodage) et une unité de visualisation ou d'affichage 37 (constituée par exemple par un écran et une imprimante avec son contrôleur associé) complètent l'ensemble.

Après cette présentation structurelle des moyens de l'invention, on va maintenant présenter les opérations "d'identification" puis "de déconvolution".

Le principe de l'identification.

Cette première étape de traitement des signaux acquis se déroule bien entendu dans le calculateur 27.

Au cours de cette opération, on cherche à obtenir une première approximation des paramètres de tension acquis après coupure, ceci par linéarisation des différentes parties de la courbe potentiel/temps correspondant aux relevés successifs de tension.

En d'autres termes, on procède ici à un lissage des signaux acquis en leur substituant des valeurs correspondant à une fonction postulée continue et monotone ayant, comme on l'a dit, avantageusement la forme $V(t) = A.t + B + C_1\,^{-t/\tau_1} + C_2\,^{-t/\tau_2}$ (l'origine des temps étant placé à l'instant $t_0$ qui correspond bien entendu au moment de la coupure du courant de protection).

Exemple d'une procédure d'identification

Supposons, en relation avec les figures que le chronorupteur 23 génére une séquence de commandes de l'ordre de 33 secondes pour la commande du contact 25, cette séquence servant également de synchronisation pour l'appareil de mesure 26. Pendant 30 secondes le contact 25 est fermé (entre 0 et $t_0$) puis ouvert pendant les 3 secondes suivantes (entre $t_0$ et $t_3$). Pendant la fermeture du contact 25, 512 points de référence sont échantillonnés, tandis que 2 048 points de mesure sont acquis à contact 25 ouvert, ces derniers points constituant l'essentiel du phénomène étudié.

Les premières données fournies correspondant aux 512 mesures de tension acquises courant de protection établi, permettent tout d'abord à l'unité de calcul 33 de fournir la valeur réelle établie de la tension U entre l'ouvrage et l'électrode lorsque ce courant circule, ceci à partir du calcul de la valeur moyenne de cette tension, soit :

$$U = \sum_{i=0}^{512} V(i) / 512 \qquad V(i) : \text{tension relevée à chaque mesure}$$

Après cela, le calculateur déterine en premier lieu les constantes A et B de la composante linéaire de V(t).

Les fonctions exponentielles étant à décroissance rapide, on préfèrera identifier les paramètres A et B à partir des points expérimentaux situés dans l'intervalle compris entre environ 1,5 et 2 secondes après courure (soit to + 1,5s et to + 2s sur la figure 3).

La methode d'identification utilisée a été celle des "moindres carrés" méthode d'approximation en soi connue qui consiste à attribuer à une grandeur déterminée par une série de mesures la valeur qui rend minimale la somme des carrés des erreurs par rapport à une fonction postulée (en l'espèce la fonction V(t)). Pour plus de détail, on pourra se reporter par exemple à la publication "méthode des moindres carrés" Y. Linnik - DUNOD - 1963.

On détermine ensuite les constantes $C_1$, $C_2$, $\tau_1$ et $\tau_2$ de la façon suivante :

Par souci de clarté, on ne présentera ci-après que le principe de calcul des constantes $C_1$ et $\tau_1$, (ce principe étant également applicable aux constantes $C_2$ et $\tau_2$)

– on soustrait tout d'abord la composante linéaire At + B de la courbe enregistrée dans l'intervalle $t_0$ à $t_1$ (entre 0 et 0,85 secondes après coupure dans l'essai mené) soit $C_1 x e^{-t/\tau 1} = V(t) - (At + B)$.

– prendre ensuite le logarithme népérien de cette valeur soit $Ln(C_1) - t/\tau_1 = Ln\ [V(t) - (At + B)]$.

La composante tangentielle est ainsi transformée en droite.

– Calculer alors les constantes $Ln(C_1)$ et $(-1/\tau_1)$ par la méthode des moindres carrés.

– En déduire $C_1$ et $\tau_1$.

Sont donc maintenant stockées en mémoire, dans l'unité 31, les valeurs "identifiées" de A, B, $C_1$ et $\tau_1$, (voire $C_2$, $\tau_2$) ainsi que la tension moyenne U avant coupure.

Mais comme on l'a dit précédemment, les valeurs des constantes des fonctions exponentielles sont intrinsèquement faussées, intégrant en elles les distorsions dues à l'unité de filtrage 11.

Les tableaux ci-dessous le montrent sans conteste

Tableau 1 : mesures de simulation avant filtrage (dans ce cas d'espèce seules les valeurs $C_1$ et $\tau_1$ ont été considérées)

| ESSAIS | A(mV/S) | B(mV) | $C_1$(mV) | $\tau_1$(ms) | U | * Saut de potentiel (mv) |
|---|---|---|---|---|---|---|
| 1 | -3 | 200 | 50 | 40 | 500 | 250 |
| 2 | -4 | 300 | 20 | 60 | 500 | 180 |
| 3 | -6 | 350 | 100 | 80 | 1050 | 550 |
| 4 | -10 | 800 | 200 | 100 | 1500 | 500 |

(*) Le saut de potentiel correspond à $U - (B + C_1)$.

Tableau 2 : mesures après passage dans le filtre

| ESSAIS | A | B | $C_1$ | $\tau_1$ | U | Saut de potentiel |
|---|---|---|---|---|---|---|
| 1 | -3 | 200 | 197 | 33 | 500 | 103 |
| 2 | -4 | 300 | 133 | 20 | 500 | 67 |
| 3 | -6 | 350 | 322 | 33 | 1000 | 328 |
| 4 | -10 | 800 | 396 | 58 | 1500 | 304 |

Pour remédier à ces variations causées à ces constantes qui faussent les résultats, on va maintenant s'attacher à reconstituer mathématiquement l'évolution des signaux de tension telle qu'elle serait sans filtre analogique et pratiquement en l'absence de parasite.

Il s'agit là comme on l'a compris de l'opération de "déconvolution".

Présentation de la "déconvolution".

Au cours de cette opération, on va en pratique soumettre le modèle postulé V(t) à une série de convolutions par la fonction de transfert du filtre que l'on aura préalablement enregistrée, (par exemple à partir d'une impulsion de tension permettant de mettre en mémoire la réponse de l'unité 11 à cette impulsion).

A l'intérieur du calculateur 27, la convoluée, c'est-à-dire résultat de chaque produit de convolution précité, est ensuite comparée au signal enregistré.

Par modification, de préférence progressive et simultanée des différents paramètres du modèle, on va alors chercher à rendre minimum l'écart quadratique moyen entre le modèle convolué par la fonction de transfert du filtre et le signal réellement enregistré.

Exemple d'une procédure de déconvolution

Lors de l'essai effectué, les calculs ont été opérés sur 80 points ce qui représentait environ 120 ms.

L'intervalle de calcul était compris entre les indices 512 (instant de la coupure, soit $t_o$) et 592 (soit $t_0$ + 120 ms).

L'algorithme choisi était fondé sur le principe de approximations successives consistant, comme connu en soi, en la minimisation d'un écart quadratique. Pour plus de détail, on pourra par exemple se reporter à la publication "An Algorithm for least square estimation of non linear parameters (Algorithme d'estimation des moindres carrés pour des paramètres non linéaires) J.Soc. Indust. and Applied Math. 11. N° 2 - MARQUARDT D.1963".

Dans le cas d'espèce, le schéma général de cet algorithme était le suivant :

1.) . Soit Ao, Bo, Co, $\tau o$ les valeurs préalablement identifiées de V(t) et $Ki_{réf}$ = écart quadratique entre la composante linéaire du modèle obtenu après identification et la composante linéaire de la fonction à déconvoluer, laquelle est bien entendu du même type que la fonction postulée V(t).

. Générer ainsi le modèle V(nT) = Ao (nT) + Bo + coe$^{(-nT/\tau o}$ dans l'intervalle de calcul (T représentant :a fréquence d'échantillonnage) avec $Ki_1$ = écart quadratique entre la fonction convoluée (soit [h(nT) * V(nT)], h(nT) étant la réponse du filtre 11) et la fonction à déconvoluer.

2.) . Calculer ensuite dc, tel que si

V(nT) = Ao(nT) + Bo + (Co + dC) $e^{(-T/\tau o)}$, on ait : dki = $Ki_2$ - $Ki_1$ < 0 avec $Ki_2$ = écart quadratique entre la convoluée [h(nT) * V(nT)] et la fonction à déconvoluer,

. Mémoriser dC,

. C suivant = Co - $Ki_1$ x$\frac{dC}{dKi}$

3.) . Calculer $d\tau$ , tel que si :

V(nT) = Ao(nT)+Bo+Coe$^{(-nT/\tau o + d\tau)}$, on ait :

dKi = $Ki_2$ - $Ki_1$ < 0 avec $Ki_2$ = écart quadratique entre [h(nT) * V(nT)] et la fonction à déconvoluer,

. Mémoriser $d\tau$ et les paramètres du modèle V(nT),

. $\tau$ suivant = $\tau o$ - $Ki_1$ x $\frac{d\tau}{dKi}$

4.) - Générer ensuite le modèle:

$$V(nT) = Ao(nT) + Bo + (Co + dC)\, e^{-nT/\tau o + d\tau)}$$

avec à chaque itiration, calcul de $Ki_3$ = écart quadratique entre [h(nT) * V(nT)] et la fonction à déconvoluer

- Si le critère d'arrêt (par exemple écart quadratique < $Ki_{réf}$) est atteint, interrompre les itérations.

Sinon recommencer en (1) en modifiant Co de façon que Co < C suivant et $\tau o$ < $\tau$ suivant, ceci jusqu'à satisfaction du critère d'arrêt.

Le tableau ci-dessous montre l'efficacité de cette méthode par approximations successives.

Tableau 3.

| ESSAIS | A | B | C | $\tau_1$ | U | Saut de potentiel |
|---|---|---|---|---|---|---|
| 1 | -3 | 200 | 57 | 50 | 500 | 243 |
| 2 | -4 | 300 | 22 | 29 | 500 | 178 |
| 3 | -6 | 350 | 97 | 50 | 1000 | 553 |
| 4 | -10 | 800 | 202 | 100 | 1500 | 498 |

NOTA : Une fois encore, seuls $C_1$ et $\tau_1$ ont été considérés .

Dans la pratique, un bon choix du modèle et des paramètres initiaux permet d'obtenir une convergence rapide de la méthode.

Ayant ainsi approché une fonction monotone représentative de ce que serait la variation monotone de potentiel de la structure mesurée sans filtre analogique et pratiquement en l'absence de parasites, il suffit ensuite d'identifier à cette fonction dont la convoluée a rendu minimum l'écart quadratique, la chute ohmique et différents phénomènes électrochimiques dont les amplitudes respectives donnent une image de la situation électrochimique existant entre le métal de l'ouvrage et le sol au moment de la coupure.

A ce sujet, on rappellera que la connaissance quantitative des amplitudes et vitesses d'évolution immédiatement après la coupure permet de déterminer quels sont les phénomènes électrochimiques qui entrent en jeu lorsque l'ouvrage, en partant de la situation de protection, évolue vers une situation de corrosion.

Parmi les différents phénomènes électrochimiques concernés, on notera en particulier les conditions typiques qui suivent :

. revêtement isolant parfait = circuit RC.

. pile Fe / $Fe^{++}$ en milieu acide

. pile Fe / $Fe^{++}$ en milieu sequestrant

. pile Fe / $Fe^{++}$ en milieu sulfures

. combinaison des trois conditions ci-dessus avec le paramètre pouvoir tampon et le paramètre $Ca^{++}$ / $CO_3H^-$

. pile H / $H^+$ dans différentes conditions de pH, de pouvoir tampon et d'accessibilité liée au paramètre $Ca^{++}$ / $CO_3H^-$,

. Pile $0_2$, $H_2O$ / $OH^-$ à différents pH, différentes concentrations et combinaison avec les paramètres pouvoir tampon et accessibilité,

. combinaison des paramètres ci-dessus avec la forme des défauts de revêtement isolant, ramenée à trois cas : piqure étroite, défaut large, revêtement poreux.

En guise de conclusion, on notera encore que la méthode de traitement des signaux acquis utilisée dans l'invention regroupe en un seul paramètre tous les phénomènes nettement plus rapides que le filtre lui-même et en un seul ensemble de deux paramètres, (amplitude et constante de temps), tous les phénomènes dont la constante de temps est voisine de celle de l'unité de filtrage.

Mais l'expérience montre que dans la pratique, ceci permet toujours l'identification des phénomènes concernés.

On peut apporter à cela deux raisons :
– il existe, dans les conditions pratiques de la protection dans le sol, pratiquement un seul phénomène chimique plus rapide que le filtre lui-même : la dépolarisation par les sulfures,
– et en outre, les phénomènes chimiques sont ici caractérisés non seulement par leur amplitude et leur constante de temps, mais aussi par le niveau de potentiel auquel ils interviennent, ces phénomènes de dépolarisation qui sont observés durant les quelques secondes qui suivent la coupure étant décomposés grâce à l'invention en un nombre restreint de manifestations physiques ou physicochimiques indépendantes, monotones et séparées en niveau de potentiel et en temps.

## Revendications

1. Procédé pour obtenir une information sur l'évolution dans le temps de la tension entre une électrode de référence (9) et un ouvrage métallique (1) tous deux en contact avec un milieu électrolytique (3), cet ouvrage étant censé être protégé contre la corrosion par un courant électrique de protection anodique ou cathodique circulant entre l'ouvrage et une contre-électrode (5) également en contact avec ledit milieu, dans lequel procédé :
   a.) on interrompt, pendant un intervalle de temps prédéterminé, la circulation dudit courant de protection,
   b.) pendant cet intervalle de temps, on relève plusieurs fois la tension entre l'ouvrage (1) et l'électrode de référence (9),
   c.) on procède à un filtrage desdits relevés de tension dans un filtre analogique (11) ayant une réponse donnée, pour obtenir des signaux filtrés,
   d.) on acquiert lesdits signaux filtrés,
   e.) on procède à un lissage de ces signaux acquis en leur substituant des valeurs correspondant à une fonction postulée de type continu et monotone (V(t)),
   f.) puis, ladite opération de filtrage ayant induit une distorsion desdits signaux acquis, on reconstitue mathématiquement l'évolution des signaux de tension entre l'ouvrage (1) et l'électrode (9) telle qu'elle serait sans un tel filtre analogique et pratiquement en l'absence de parasites électriques.

2. Procédé selon la revendication 1 caractérisé en ce que pendant l'étape f.) :
   – on conduit une transformation de convolution entre la réponse du filtre analogique (11) et une fonction de même type que ladite fonction postulée V(t) et on compare la convoluée obtenue à ladite fonction postulée,
   – on réitère l'étape ci-dessus jusqu'à obtenir la fonction dont la convoluée s'approche avec un écart donné de ladite fonction postulée,
   – et on assimile cette fonction à l'évolution dans le temps de ladite tension entre l'ouvrage (1) et l'électrode (9) pendant l'intervalle de temps où le courant de protection est coupé.

3. Procédé selon la revendication 1 ou la revendication 2 caractérisé en ce que ladite fonction postulée V(t) consiste en une modélisation mathématique d'une évolution de la tension entre l'ouvrage (1) et l'électrode (9) en fonction du temps constituée d'un saut de tension suivi d'une somme d'au moins une exponentielle et d'un polynôme.

4. Procédé selon l'une quelconque des revendications précédentes caractérisé en ce que ladite fonction postulée est du type $V(t) = At + B + C_1 e^{-t/\tau 1} + C_2{}^{-t/\tau 2}$,
   A, B, $C_1$, $C_2$, $\tau_1$, $\tau_2$, étant des constantes ayant lesdites valeurs de substitution de l'étape e) de la revendication 1.

5. Procédé selon l'une quelconque des revendications 2 à 4 caractérisé en ce qu'on assimile à l'évolution dans le temps de la tension ouvrage/électrode courant de protection coupé, ladite fonction mathématique dont la convoluée s'approche avec un écart donné de ladite fonction postulée (V(t)), en identifiant cette fonction mathématique avec des phénomènes de dépolarisation existant pendant ladite coupure de courant, ces phénomènes étant décomposés en une série de manifestations physiques ou physico-chimiques indépendantes, monotones et séparées en tension et dans le temps.

6. Procédé selon l'une quelconque des revendications précédentes caractérisé en ce que lors du lissage de l'étape e) de la revendication 1, on détermine les valeurs à substituer auxdits signaux filtrés acquis par la

méthode des "moindres carrés".

7. Procédé selon l'une quelconque des revendications 2 à 6 caractérisé en ce qu'on fait converger par la méthode des "approximations successives" la fonction postulée et la convoluée résultant de l'opération de convolution entre la réponse du filtre analogique (11) et ladite fonction de même type que cette fonction postulée.

8. Procédé selon l'une quelconque des revendications précédentes caractérisé en ce qu'il comprend en outre les étapes suivantes :
g) on rétablit la circulation dudit courant de protection pendant un nouvel intervalle de temps déterminé,
h) on répète les étapes b), c), d) de la revendication 1,
i) on calcule statistiquement la valeur moyenne des signaux de l'étape e), ces signaux étant représentatifs de l'évolution dans le temps de la tension entre l'ouvrage (1) et l'électrode (9) courant de protection établi,
j) et, on fournit sur une unité de visualisation (37) des informations correspondant à ces signaux et à ladite reconsitution mathématique menée lors de l'opération f) de la revendication 1.

9. Appareil pour fournir une information sur l'évolution dans le temps de la tension entre une électrode de référence (9) et un ouvrage métallique (1) tous deux en contact avec un milieu électrolytique, cet ouvrage étant censé être protégé contre la corrosion par un courant de protection anodique ou cathodique circulant entre l'ouvrage et une contre-électrode (5) également en contact avec ledit milieu (3), caractérisè en ce qu'il comprend :
– des moyens (7, 23, 25) pour établir et interrompre pendant des intervalles de temps donnés la circulation dudit courant de protection,
– des capteurs (13, 26) pour effectuer des relevés échantillonnés de la tension entre l'ouvrage (1) et l'électrode de référence (9) courant établi et courant interrompu,
– un filtre analogique (11) qui reçoit lesdits relevés de tension et délivre des signaux filtrés,
– des unités d'acquisition (29) desdits signaux filtrés et de traitement (31, 33, 27) desdits signaux acquis pour lisser ces signaux en leur substituant des valeurs correspondant à une fonction postulée de type continue et monotone (V(t)) et pour approcher mathématiquement par essais successifs une fonction de même type que ladite fonction postulée, cette fonction étant représentative de l'évolution monotone de la tension entre l'ouvrage (1) et l'électrode (9) telle qu'elle serait sans filtre analogique et pratiquement en l'absence de parasites électriques,
– et des moyens (37) d'affichage pour fournir à un opérateur des informations correspondant à ladite fonction approchée.

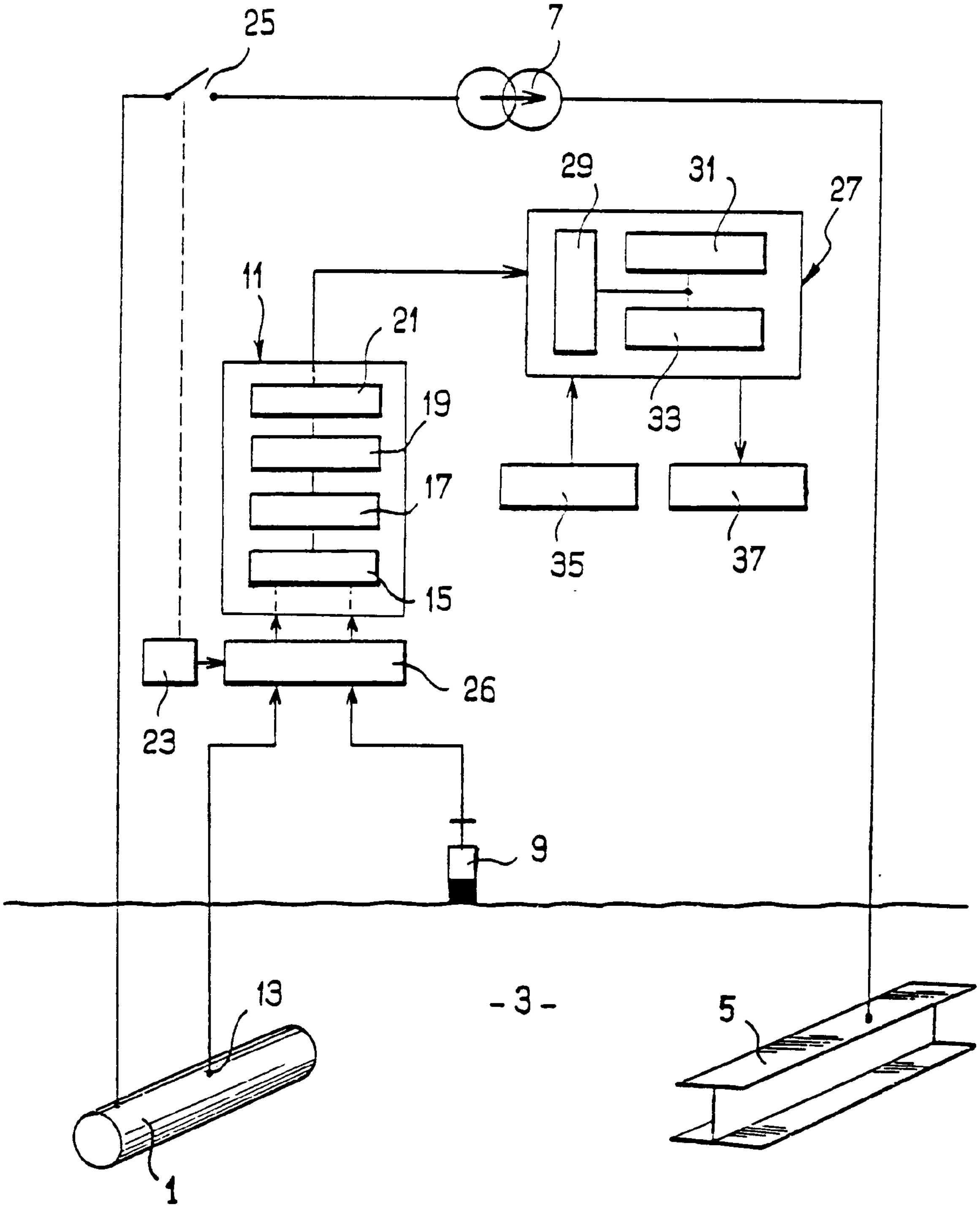


FIG_1

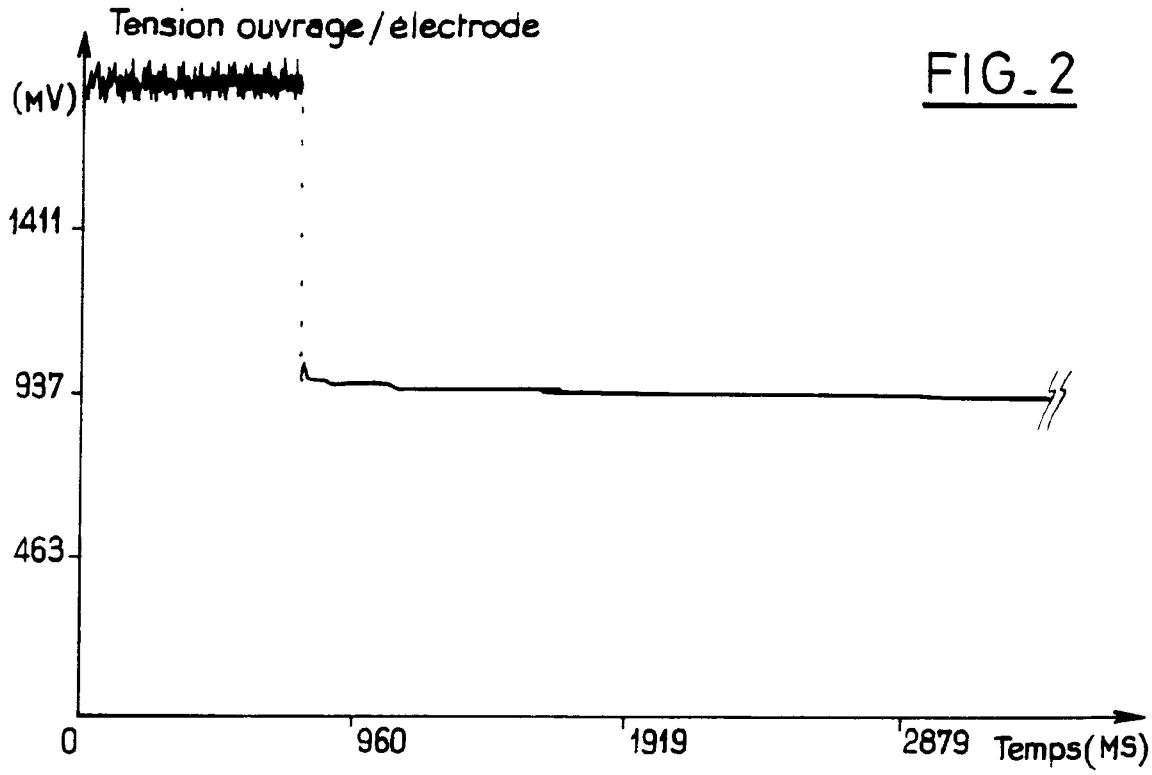
Tension ouvrage / électrode
(MV)
1411
937
463
0
960
1919
2879
Temps(MS)

FIG_2

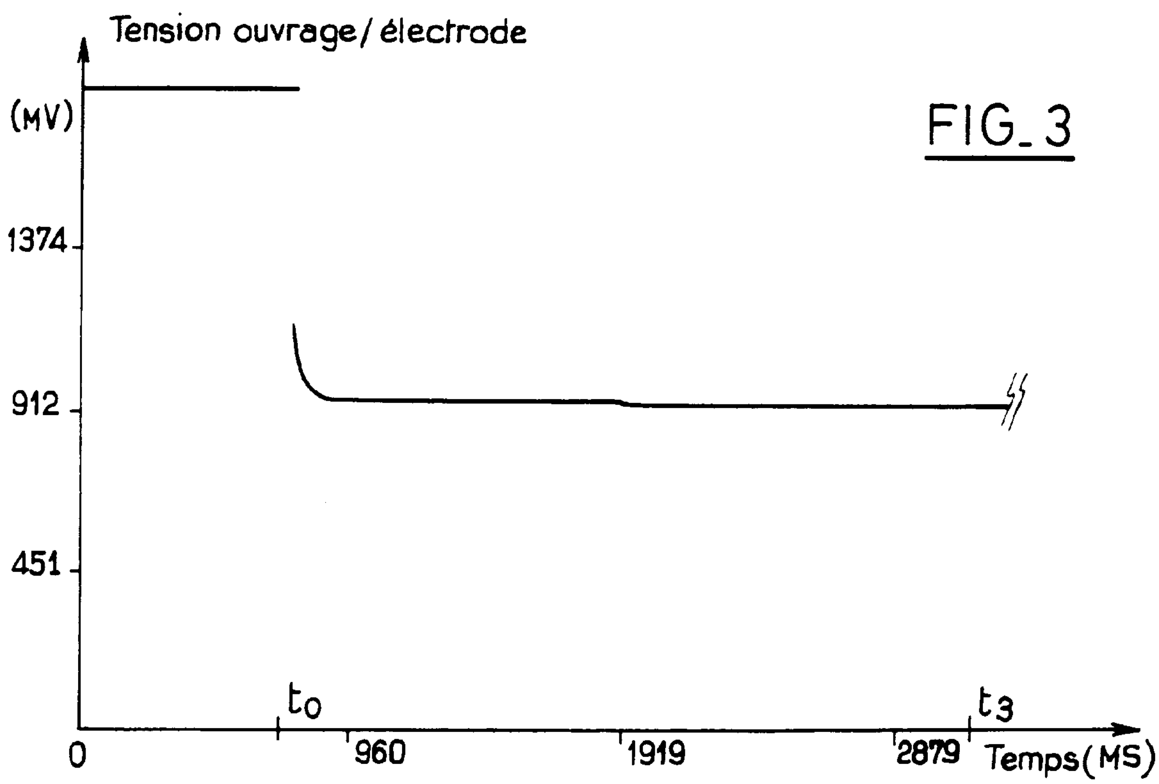
Tension ouvrage / électrode
(MV)
1374
912
451
0
$t_0$
960
1919
2879
$t_3$
Temps(MS)

FIG_3

Office européen des brevets

# RAPPORT DE RECHERCHE EUROPEENNE

Numero de la demande

EP 91 40 3502

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 591 792 (J.R. BIRCHMEIER et al.)<br>* abrégé; colonne 1, ligne 20 - colonne 3, ligne 4; colonne 4, ligne 51 - colonne 5, ligne 57; figures 1-4 * | 1,2,5-9 | G 01 N 17/00<br>C 23 F 13/00 |
| Y | EXTENDED ABSTRACTS vol. 84, no. 2, octobre 1984, page 265, Princeton, New Jersey, US; D. BRITZ: "The use of a computer in the corrosion laboratory"<br>* document entier * | 1,2,5-9 | |
| A | ELECTROCHEMICAL CORROSION TESTING 1981, pages 110-149; D.D. MACDONALD et al.: "Electrochemical Impedance Techniques in Corrosion Science"<br>* page 139, ligne 10 - page 140, ligne 34; page 141: table 1 * | 3,4 | |
| A | JOURNAL OF THE ELECTROCHEMICAL SOCIETY vol. 130, no. 12, décembre 1983, pages 2329-2334, Manchester, New Hampshire, US; M. ROSEN et al.: "Tafel Constants and Changes in Hydrogen Coverage during Corrosion of Fe18Cr"<br>* abrégé; page 2329, colonne 1, ligne 1 - page 2332, colonne 1, ligne 30; page 2334: Appendices A,B * | 1-9 | DOMAINES TECHNIQUES RECHERCHES (Int. Cl.5)<br>G 01 N<br>C 23 F<br>G 06 F |
| A | US-A-4 658 365 (B.C. SYRETT et al.)<br>* document entier * | 1-9 | |
| A | EP-A-0 208 848 (CONSIGLIO NAZIONALE DELLE RICERCHE)<br>* colonne 1, ligne 1 - colonne 8, ligne 9; figures 1,3 * | 1-9 | |

Le présent rapport a été établi pour toutes les revendications

| Lieu de la recherche | Date d'achèvement de la recherche | Examinateur |
|---|---|---|
| BERLIN | 02-04-1992 | MOUTARD P.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)